(19) **Europäisches Patentamt / European Patent Office / Office européen des brevets**

(11) **EP 4 751 824 A1**

(12) # EUROPEAN PATENT APPLICATION
published in accordance with Art. 153(4) EPC

(43) Date of publication:
**03.06.2026 Bulletin 2026/23**

(21) Application number: **24845405.0**

(22) Date of filing: **10.07.2024**

(51) International Patent Classification (IPC):
**B22F 1/00** (2022.01)     **B22F 1/05** (2022.01)
**B22F 9/04** (2006.01)     **C22C 1/00** (2023.01)
**C22C 1/02** (2006.01)     **C22C 1/04** (2023.01)
**C22C 1/047** (2023.01)     **C22C 19/07** (2006.01)

(52) Cooperative Patent Classification (CPC):
**H10N 15/10; B22F 1/00; B22F 1/05; B22F 9/04;**
**C22C 1/00; C22C 1/02; C22C 1/04; C22C 1/047;**
**C22C 19/07; H01F 1/0009**

(86) International application number:
**PCT/JP2024/024980**

(87) International publication number:
**WO 2025/023024 (30.01.2025 Gazette 2025/05)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **24.07.2023 JP 2023119587**

(71) Applicants:
• **The University of Tokyo
Bunkyo-ku, Tokyo 113-8654 (JP)**
• **Dowa Holdings Co., Ltd.
Tokyo 101-0021 (JP)**

(72) Inventors:
• **SAKAI, Akito
Tokyo 113-8654 (JP)**
• **NAKATSUJI, Satoru
Tokyo 113-8654 (JP)**
• **SATO, Kimitaka
Tokyo 101-0021 (JP)**
• **KUMON, Shoichi
Tokyo 101-0021 (JP)**
• **KATO, Shogo
Tokyo 101-0021 (JP)**

(74) Representative: **Pritzlaff, Stefanie Lydia
Wagner & Geyer Partnerschaft mbB
Patent- und Rechtsanwälte
Gewürzmühlstraße 5
80538 München (DE)**

(54) **GD-CO-BASED METALLIC POWDER, METHOD FOR PRODUCING SAME, ELECTROCONDUCTIVE MOLDED BODY, AND THERMOELECTRIC CONVERSION ELEMENT**

(57)     [Problem] To provide a technique suitable for producing, with high productivity, a thermoelectric conversion element that utilizes an anomalous Nernst effect to obtain a high Nernst coefficient in a zero magnetic field.

[Solution] A metallic powder which is a powder containing an intermetallic compound $GdCo_5$ as a main component, and has a cumulative 50% particle diameter D50 of 1 to 150 $\mu m$ and a cumulative 90% particle diameter D90 of 250 $\mu m$ or less in a volume-based particle size distribution as determined by a laser diffraction/scattering method. This metallic powder can be obtained, for example, by pulverizing an alloy ingot containing an intermetallic compound $GdCo_5$ as a main component.

[Fig.8]

## Description

Technical Field

The present invention relates to a Gd-Co-based metallic powder that is useful as a material for a thermoelectric conversion element, and a method for producing the same. The invention also relates to an electroconductive molded body of a Gd-Co-based metallic powder, and a thermoelectric conversion element formed using the electroconductive molded body.

Background Art

In recent years, a study of a thermoelectric conversion element utilizing an anomalous Nernst effect has been progressing. The anomalous Nernst effect is a phenomenon in which, when a heat flow perpendicular to the magnetization is applied to a spontaneously magnetized magnetic body, an electromotive force is generated in a direction perpendicular to both magnetization and heat flow. When the anomalous Nernst effect is utilized, an electric current can be extracted in a direction perpendicular to the heat flow, which provides an advantage of being able to construct a thermoelectric conversion device formed into a thin sheet unlike a case where an Seebeck effect is utilized. For example, a ferromagnetic intermetallic compound $Co_2MnGa$ is known as a material that exhibits a large anomalous Nernst effect at normal temperature.

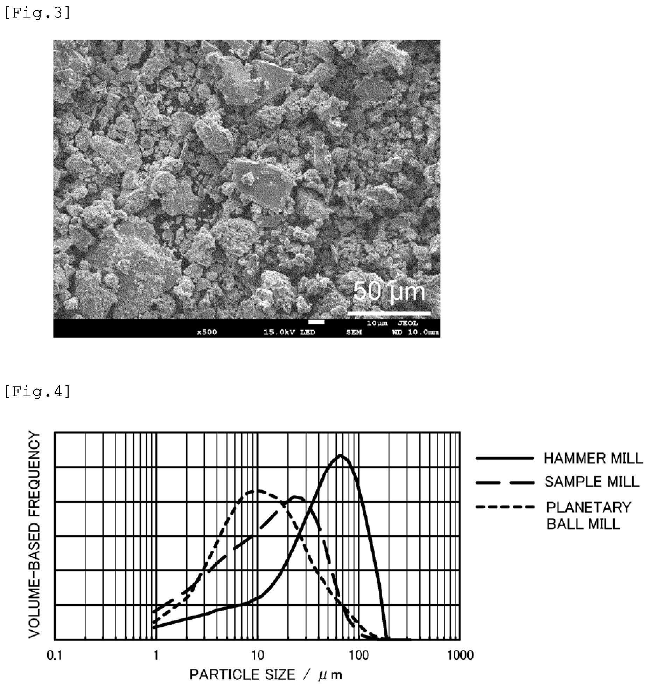

PTL 1 describes an experimental example in which a $Co_2MnGa$ single crystal was produced by a Czochralski method and a Nernst coefficient was measured. The Nernst coefficient of the $Co_2MnGa$ single crystal at normal temperature (300 K) reaches a high value of about 6 $\mu$V/K regardless of whether the magnetic field application direction is parallel to the [100], [110], or [111] direction of the crystal (paragraph 0021 and FIG. 4).

PTL 2 describes that an anomalous Nernst material film is used for a heat flow sensor in a composite sensor having the heat flow sensor and a temperature sensor. Several materials are listed as the anomalous Nernst material (paragraph 0026). A sputtering method is shown as a method for forming the anomalous Nernst material film (paragraph 0030).

Examples of a main application of a thermoelectric conversion element include a thermoelectric power generation device and a heat flow sensor.

The thermoelectric conversion element for realizing a thermoelectric power generation device is desirably a bulk body with a thickness of about several millimeters. It is possible to prepare a bulk body of a size as described above when a single crystal formed by a Czochralski method is used. However, a single crystal production technique such as a Czochralski method requires high cost and has low productivity, and therefore is impractical for industrial production of a material for a thermoelectric power generation device. On the other hand, it is difficult to apply a film formation technique such as a sputtering method to the industrial production of a bulk material for a thermoelectric power generation device.

A thermoelectric conversion element for realizing a heat flow sensor is desirably a small-sized element in consideration of use by being incorporated into a part of a microcircuit pattern. Cutting a large number of small-sized elements from a single crystal obtained by a Czochralski method or other methods is difficult to industrially put into practical use in terms of cost. It is also difficult to directly form a small-sized element of a predetermined shape using a Czochralski method. On the other hand, according to a film formation technique such as a sputtering method, it is possible to form a small-sized element corresponding to a predetermined circuit pattern directly on an insulating substrate. However, such a film formation method has low productivity, and the production cost of a heat flow sensor is high.

PTL 3 discloses a powder of $Co_2MnGa$ as a material that can be widely applied to the production of thermoelectric conversion elements of various shapes and sizes. In an electroconductive molded body formed using this powder, a high Nernst coefficient is obtained in the same manner as in single crystal $Co_2MnGa$.

On the other hand, PTL 4 describes that an antiferromagnetic $Mn_3Sn$ powder exhibits a coercive force of about 0.25 to 0.5 T and exhibits a thermoelectric conversion action due to an anomalous Nernst effect even in the absence of an applied magnetic field (hereinafter, this is sometimes referred to as "zero magnetic field").

Citation List

Patent Literature

PTL 1: WO2019/009308
PTL 2: JP2020-153668A
PTL 3: JP2023-2425A

PTL 4: JP2021-145116A

Summary of Invention

Technical Problem

At present, a material that exhibits a high Nernst coefficient such as the above-mentioned $Co_2MnGa$ is known. However, since $Co_2MnGa$ has a poor coercive force, a thermoelectric conversion action due to an anomalous Nernst effect can hardly be obtained in the absence of an applied magnetic field (zero magnetic field). It is assumed that the thermoelectric conversion element used in a sensor is placed in a small space inside an electronic apparatus, and it is practically difficult to mount the thermoelectric conversion element together with a strong magnet in the device. Therefore, it is desirable to apply a material that exhibits a thermoelectric conversion action even in a zero magnetic field to the thermoelectric conversion element.

On the other hand, when the $Mn_3Sn$ powder disclosed in PTL 4 is used, it is possible to obtain a thermoelectric conversion action even in a zero magnetic field. However, the Nernst coefficient is considerably smaller than that of $Co_2MnGa$, and is not sufficient for constructing a practical thermoelectric conversion element. In addition, although the coercive force of the $Mn_3Sn$ powder is said to be about 0.25 to 0.5 T (PTL 4), in order to provide reliability that ensures a stable and high thermoelectric conversion action even when it is exposed to a disturbance caused by a magnetic field or the like generated from an apparatus, it is desirable to develop a material that exhibits an anomalous Nernst effect and has a higher coercive force.

An object of the invention is to provide a new material that has a high coercive force, exhibits a high Nernst coefficient in a zero magnetic field, and is easily applied widely to the production of thermoelectric conversion elements of various shapes and sizes. Another object is to provide a thermoelectric conversion element with a high Nernst coefficient obtained using the material.

Solution to Problem

In order to achieve the above objects, the present description discloses the following inventions.
[1] A metallic powder, which is a powder containing an intermetallic compound $GdCo_5$ as a main component, and has a cumulative 50% particle diameter D50 of 1 to 150 $\mu$m and a cumulative 90% particle diameter D90 of 250 $\mu$m or less in a volume-based particle size distribution as determined by a laser diffraction/scattering method.
[2] A method for producing the metallic powder according to the above [1], including:

an alloy ingot preparation step of solidifying a molten metal of a Gd-Co-based alloy to obtain an alloy ingot containing an intermetallic compound $GdCo_5$ as a main component; and
a pulverizing step of pulverizing the alloy ingot to obtain a powder.

[3] An electroconductive molded body of a powder containing an intermetallic compound $GdCo_5$ as a main component.
[4] The electroconductive molded body according to the above [3], wherein the powder containing an intermetallic compound $GdCo_5$ as a main component has a cumulative 50% particle diameter D50 of 1 to 150 $\mu$m and a cumulative 90% particle diameter D90 of 250 $\mu$m or less in a volume-based particle size distribution as determined by a laser diffraction/scattering method.
[5] The electroconductive molded body according to the above [3] or [4], which is a sintered body of a powder containing an intermetallic compound $GdCo_5$ as a main component.
[6] The electroconductive molded body according to any one of the above [3] to [5], which exhibits a Nernst coefficient of 0.2 $\mu$V/K or more at a temperature of 300 K in the absence of an applied magnetic field.
[7] A thermoelectric conversion element, formed using the electroconductive molded body according to any one of the above [3] to [6].

Advantageous Effects of Invention

According to the invention, it is possible to obtain a thermoelectric conversion element that exhibits a high Nernst coefficient in a zero magnetic field and has excellent resistance to a disturbance caused by an external magnetic field. Since the material used for the thermoelectric conversion element is a powder, the technique of the invention can be widely applied to elements of various shapes and sizes. Further, the technique of the invention is superior in terms of cost and productivity as compared with a technique using a single crystal or a thin film formed by a sputtering method.

Brief Description of Drawings

[FIG. 1] FIG. 1 is an SEM photograph of a Gd-Co-based metallic powder which is a hammer mill-pulverized product.
[FIG. 2] FIG. 2 is an SEM photograph of a Gd-Co-based metallic powder which is a sample mill-pulverized product.
[FIG. 3] FIG. 3 is an SEM photograph of a Gd-Co-based metallic powder which is a planetary ball mill-pulverized product.
[FIG. 4] FIG. 4 is a graph illustrating particle size distribution curves of a hammer mill-pulverized product, a sample mill-pulverized product, and a planetary ball mill-pulverized product with respect to a Gd-Co-based metallic powder obtained in Example 1.
[FIG. 5] FIG. 5 is a view illustrating X-ray diffraction patterns of a hammer mill-pulverized product, a sample mill-pulverized product, and a planetary ball mill-pulverized product with respect to a Gd-Co-based metallic powder obtained in Example 1.
[FIG. 6] FIG. 6 is a graph illustrating magnetization curves of a hammer mill-pulverized product, a sample mill-pulverized product, and a planetary ball mill-pulverized product with respect to a Gd-Co-based metallic powder obtained in Example 1.
[FIG. 7] FIG. 7 is a diagram schematically showing the attachment positions of terminals for electromotive force measurement and probes for temperature measurement, as well as the directions of heat flow and magnetic field application with respect to a sample for Nernst effect measurement.
[FIG. 8] FIG. 8 is a graph showing the measurement results of a Nernst coefficient with respect to an electroconductive molded body of a $GdCo_5$ powder, which is a sample mill-pulverized product.

Description of Embodiments

[Gd-Co-based Metallic Powder]

In the invention, a Gd-Co-based metallic powder containing an intermetallic compound $GdCo_5$ as a main component is applied as a material suitable for a thermoelectric conversion element. The intermetallic compound $GdCo_5$ has a hexagonal crystal structure and exhibits antiferromagnetism at normal temperature.

In a composition range where the composition ratio of Gd (gadolinium) and Co (cobalt) is close to the stoichiometric composition of $GdCo_5$, an intermetallic compound having a $GdCo_5$-type crystal structure can exist stably as a single phase. It is considered that a Gd-Co-based alloy in which an intermetallic compound phase having a $GdCo_5$-type crystal structure and a heterogeneous phase are mixed can be obtained around that composition range. Even if the composition is slightly different from the stoichiometric composition of $GdCo_5$, a crystal phase having a $GdCo_5$-type crystal structure (that is, a crystal structure in which a diffraction peak corresponding to a diffraction peak from each crystal face of a $GdCo_5$ crystal with a stoichiometric composition is observed in an X-ray diffraction pattern) is included in the "intermetallic compound $GdCo_5$ as used herein.

The "powder containing an intermetallic compound $GdCo_5$ as a main component" means a powder in which the relationship $I_1 < I_0$ holds when, in the X-ray diffraction pattern of the powder, the integrated intensity of a diffraction peak with the highest peak among the diffraction peaks of the $GdCo_5$-type crystal structure is denoted by $I_0$, and the integrated intensity of a diffraction peak with the highest peak among the diffraction peaks of a heterogeneous phase (a phase other than the crystal phase of the $GdCo_5$-type crystal structure) is denoted by $I_1$. Here, if no heterogeneous phases are detected, $I_1 = 0$, and the above relationship $I_1 < I_0$ is satisfied. In a thermoelectric conversion element formed using a powder containing an intermetallic compound $GdCo_5$ as a main component, even if a heterogeneous phase other than the $GdCo_5$ phase is contained, a thermoelectric conversion action due to the anomalous Nernst effect of the $GdCo_5$ phase occurs. However, in order to achieve efficient thermoelectric conversion properties, it is desirable that the existing amount of a heterogeneous phase that does not show the anomalous Nernst effect is small. For example, it is preferable to satisfy $I_1 < 0.5I_0$, and it is more preferable to satisfy $I_1 < 0.3I_0$. As a particularly preferable powder, a $GdCo_5$ single-phase powder in which no heterogeneous phases are detected is exemplified.

As for the particle size distribution of the particles constituting the Gd-Co-based metallic powder, the cumulative 50% particle diameter D50 is in the range of 1 μm or more and 150 μm or less, and the cumulative 90% particle diameter D90 is in the range of 250 μm or less in the volume-based particle size distribution as determined by a laser diffraction/scattering method. If the cumulative 50% particle diameter D50 is too large, the average particle diameter is large, which leads to a decrease in coercive force. If the cumulative 90% particle diameter D90 is too large, the existing proportion of coarse particles is large, which also leads to a decrease in coercive force. The optimum particle size distribution conditions vary depending on the application or the production process of the element, but the optimum conditions can usually be set within the above particle size distribution range. In view of the importance placed on ensuring the coercive force, the cumulative 50% particle diameter D50 is preferably 70 $\mu$m or less, more preferably 50 $\mu$m or less, and still more preferably 20 $\mu$m or less. Further, the cumulative 90% particle diameter D90 is preferably 150 $\mu$m or less, more preferably 120 $\mu$m or less, and still more preferably 60 $\mu$m or less.

As a method for producing the Gd-Co-based metallic powder, it is possible to apply, for example, a process including:

an alloy ingot preparation step of solidifying a molten metal containing Gd and Co to obtain an alloy ingot containing an intermetallic compound $GdCo_5$ as a main component; and
a pulverizing step of pulverizing the alloy ingot to obtain a powder.
If necessary, a classification step of classifying the powder obtained in the pulverizing step using a sieve or the like,

may be further performed.

The molten metal of a Gd-Co-based alloy can be obtained by a method in which the respective raw material metals of Gd and Co weighed to a predetermined composition are melted by, for example, a plasma arc or a method in which the respective raw material metals are heated and melted in a crucible. The molten metals are solidified to obtain an alloy ingot containing an intermetallic compound $GdCo_5$ as a main component. Since the intermetallic compound $GdCo_5$ is relatively brittle, the alloy ingot can be powdered by a mechanical pulverizing means. For example, the particle size can be adjusted to a desired size by utilizing a known pulverizing means such as a hammer mill, a sample mill, or a planetary ball mill. In addition, in order to adjust the final particle size distribution, the powder obtained by the pulverizing means can also be classified by a sieve.

The Gd-Co-based metallic powder of the invention can be used as a material for a thermoelectric conversion element.

[Electroconductive Molded Body]

In the present description, an object molded into a predetermined shape using a powder as a material and having shape retention that allows the object to maintain its shape in the usage environment is called a "molded body of a powder". In particular, a molded body of a powder having electroconductivity is called an "electroconductive molded body of a powder". An electroconductive molded body of a powder containing an intermetallic compound $GdCo_5$ as a main component, formed using the above-mentioned Gd-Co-based metallic powder as a material is useful as a thermoelectric conversion element.

Examples of a typical form of the electroconductive molded body of a powder include a green compact and a sintered body. Even a green compact can be used as a thermoelectric conversion element by being incorporated into a device so that the shape retention can be maintained in the usage environment. In order to ensure stable shape retention, a sintered body is preferable.

Examples of the form of the electroconductive molded body of a powder other than the green compact and the sintered body include a molded body formed by solidifying a powder into a predetermined shape using a binder component such as a resin. When a binder component having no electroconductivity is used, the powder needs to be solidified in a state where the powder particles are in contact with one another. When a binder component having electroconductivity is used, contact of the powder particles is not essential.

When a sintered body is applied as the electroconductive molded body of a powder containing an intermetallic compound $GdCo_5$ as a main component, a sintered body of a powder containing an intermetallic compound $GdCo_5$ as a main component can be prepared by utilizing a known sintering method. When a part or all of a circuit pattern formed on an insulating substrate is used as the electroconductive molded body of a powder containing an intermetallic compound $GdCo_5$ as a main component, a method in which a coating film of a circuit pattern is formed on an insulating substrate with a coating material containing the powder as a filler, and then the coating film is heated and sintered, or the like can be applied.

When a Gd-Co-based metallic powder adjusted to the particle size distribution described above is used as a material, it is possible to construct an electroconductive molded body that has a large coercive force and exhibits an excellent thermoelectric conversion action in a zero magnetic field environment at normal temperature.

Examples

[Example 1]

(Preparation of Alloy Ingot)

Metallic Gd (manufactured by Nippon Yttrium Co., Ltd., purity: 3N) and metallic Co (manufactured by Rare Metallic Co., Ltd., purity: 3N), which are raw materials, were weighed out so that the atomic ratio satisfied Ga:Co = 1.0:5.0. A molten metal of a Ga-Co alloy was formed in an argon atmosphere using an arc melting furnace (manufactured by Nisshin Giken Co., Ltd.), and solidified on a water-cooled copper plate to obtain about 50 g of an alloy ingot.

(Preparation of Powder)

The obtained alloy ingot was coarsely pulverized in a mortar in a glove box with a nitrogen atmosphere. The pulverized product at this stage is called "coarsely pulverized product". The following three types of pulverized products were prepared using this coarsely pulverized product.

(i) Hammer Mill-Pulverized Product

The coarsely pulverized product was pulverized in the glove box using a hammer mill (Hammer Crusher NH-34S, screen mesh: 0.3 mm, manufactured by Sansho Industry Co., Ltd.) to obtain a hammer mill-pulverized product.

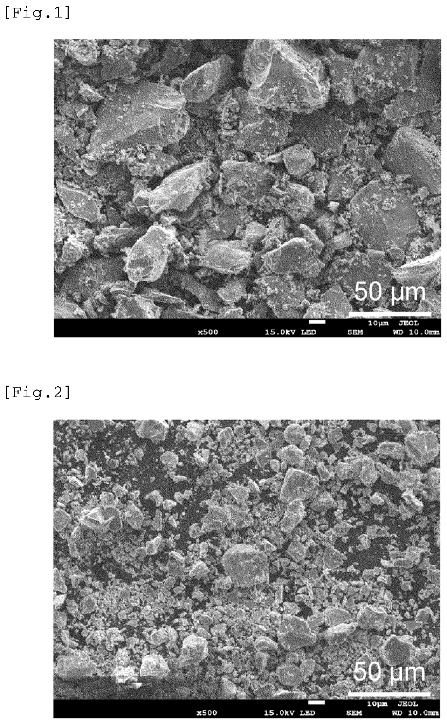

FIG. 1 illustrates an SEM (scanning electron microscope) photograph of the hammer mill-pulverized product. The SEM used is FE-SEM JSM-7200F manufactured by JEOL Ltd. (the same applies to each of the following pulverized products).
The hammer mill-pulverized product was subjected to an elemental analysis using an EDX (energy dispersive X-ray analysis) apparatus (X-Max20, manufactured by Oxford Instruments) attached to the SEM (the same was done for each of the following pulverized products). As a result, the composition of the hammer mill-pulverized product satisfied Ga:Co = 1.2:5.0 in atomic ratio, and the oxygen content was 1.0 mass%.
The particle size distribution of the hammer mill-pulverized product was measured using a dry laser diffraction particle size distribution analyzer (HELOS & RODOS, manufactured by Japan Laser Co., Ltd.) with a lens having a focal length of 200 mm (the same was done for each of the following pulverized products). As a result, the hammer mill-pulverized product had a volume-based cumulative 10% particle diameter D10 of 5 $\mu$m, a cumulative 50% particle diameter D50 of 44 $\mu$m, and a cumulative 90% particle diameter D90 of 111 $\mu$m, all as measured by a laser diffraction/-scattering method.

(ii) Sample Mill-Pulverized Product

A part of the hammer mill-pulverized product was pulverized in the glove box with a sample mill (model: SK-M10, manufactured by Kyoritsu Riko Co., Ltd.) to obtain a sample mill-pulverized product.
FIG. 2 illustrates an SEM photograph of the sample mill-pulverized product.
The composition of the sample mill-pulverized product as measured by EDX satisfied Ga:Co = 1.1:5.0 in atomic ratio, and the oxygen content was 1.0 mass%. Further, the sample mill-pulverized product had a volume-based cumulative 10% particle diameter D10 of 2 $\mu$m, a cumulative 50% particle diameter D50 of 13 $\mu$m, and a cumulative 90% particle diameter D90 of 44 $\mu$m, all as measured by a laser diffraction/scattering method.

(iii) Planetary Ball Mill-Pulverized Product

A part of the hammer mill-pulverized product was pulverized with a planetary ball mill (P-7, manufactured by Fritsch GmbH) placed in a sealed container with a nitrogen atmosphere to obtain a planetary ball mill-pulverized product.
FIG. 3 illustrates an SEM photograph of the planetary ball mill-pulverized product.
The composition of the planetary ball mill-pulverized product as measured by EDX satisfied Ga:Co = 1.1:5.0 in atomic ratio, and the oxygen content was 1.3 mass%. Further, the planetary ball mill-pulverized product had a volume-based cumulative 10% particle diameter D10 of 3 $\mu$m, a cumulative 50% particle diameter D50 of 10 $\mu$m, and a cumulative 90% particle diameter D90 of 40 $\mu$m, all as measured by a laser diffraction/scattering method.
FIG. 4 shows the particle size distribution curves of the hammer mill-pulverized product, the sample mill-pulverized product, and the planetary ball mill-pulverized product.

(Measurement of X-Ray Diffraction Pattern)

With respect to each powder of the hammer mill-pulverized product, the sample mill-pulverized product, and the planetary ball mill-pulverized product, the X-ray diffraction pattern was measured using an X-ray diffractometer (Ultima IV, manufactured by Rigaku Corporation) under the following conditions: Cu-K$\alpha$ radiation, tube voltage: 40 kV, tube current:

40 mA, measurement step: 0.02°, and scan speed: 2°/min.

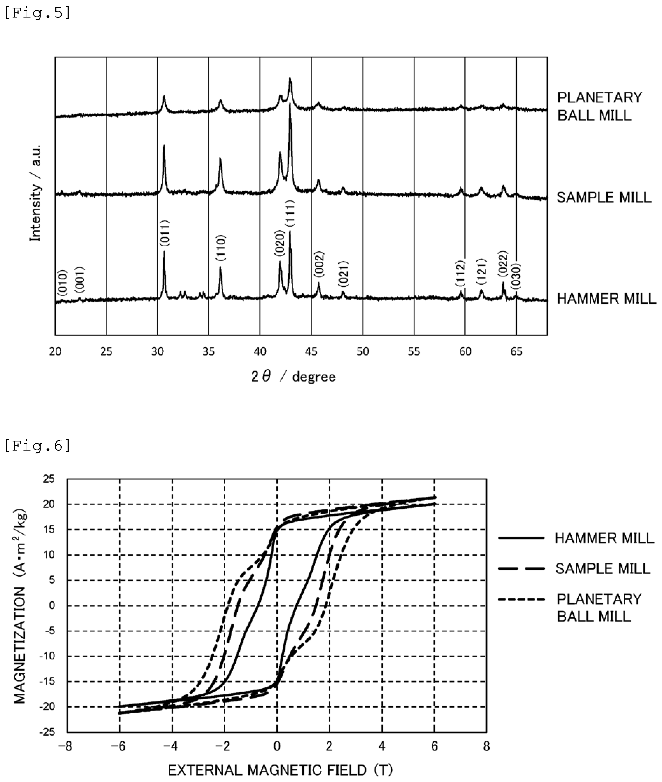

FIG. 5 illustrates the X-ray diffraction patterns. All the pulverized products exhibited a diffraction pattern of a hexagonal $GaCo_5$ crystal, and it was verified that the products are powders formed of a substantially single-phase $GaCo_5$ crystal phase.

(Measurement of Powder Magnetic Properties)

The magnetic properties of each powder sample of the hammer mill-pulverized product, the sample mill-pulverized product, and the planetary ball mill-pulverized product at room temperature were measured using a VSM (Model-5, manufactured by Toei Kogyo Co., Ltd.). The measurement conditions were set as follows: maximum applied magnetic field: 6 T, and sweep speed: 1 min/F.S. As a result of the measurement, the magnetization of each pulverized product appeared to be unsaturated in a magnetic field of 6 T, and the magnetization at a magnetic field of 6 T was 20.0 $A \cdot m^2$/kg in the case of the hammer mill-pulverized product, 21.3 $A \cdot m^2$/kg in the case of the sample mill-pulverized product, and 21.3 $A \cdot m^2$/kg in the case of the planetary ball mill-pulverized product. Further, the coercive force was 0.74 T (589 kA/m) in the case of the hammer mill-pulverized product, 1.48 T (1178 kA/m) in the case of the sample mill-pulverized product, and 1.86 T (1480 kA/m) in the case of the planetary ball mill-pulverized product.

FIG. 6 shows the magnetization curves of the hammer mill-pulverized product, the sample mill-pulverized product, and the planetary ball mill-pulverized product.

(Preparation of Electroconductive Molded Body)

As electroconductive molded bodies of a powder, respective sintered bodies were prepared as follows using each powder of the hammer mill-pulverized product, the sample mill-pulverized product, and the planetary ball mill-pulverized product. About 5 g of a powder of each pulverized product was heated with a discharge plasma sintering apparatus in a vacuum atmosphere of about 1 Pa while applying a pressure of 90 MPa (7.065 kN) with upper and lower pistons in a cylinder of a cylindrical graphite cell with an inner diameter of 10 mm to obtain a sintered body in a cylindrical shape with a diameter of 10 mm and a height of about 8 mm. The heating pattern was such that the temperature was raised to 500°C and held at 500°C for 10 minutes, and then the resultant was allowed to cool.

(Measurement of Anomalous Nernst Effect)

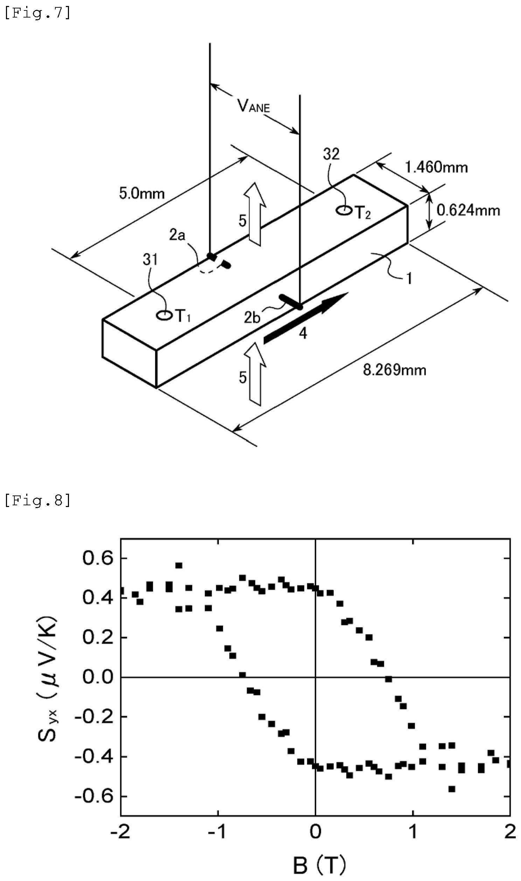

A rectangular parallelepiped sample with a length ($L_1$) of about 8.0 mm, a width (W) of about 1.5 mm, and a thickness (H) of about 0.5 mm was cut out from the electroconductive molded body (sintered body). FIG. 7 schematically shows the attachment positions of terminals for electromotive force measurement and probes for temperature measurement, as well as the directions of heat flow and magnetic field application. Terminals 2a and 2b for electromotive force measurement were attached to center positions of the opposing side surfaces of a sample for Nernst effect measurement 1 with an electroconductive epoxy adhesive, so that a voltage (V) generated between the two terminals could be measured with a voltmeter. This voltage is generated by the anomalous Nernst effect, and is therefore denoted by $V_{ANE}$. Probes for temperature measurement were attached with an electroconductive epoxy adhesive to two places (positions indicated by symbols 31 and 32) on the top surface of the sample 1 at an interval ($L_2$) of 5.0 mm so that the temperature difference $\Delta T$ therebetween could be monitored, and a magnetic field was applied in the thickness direction of the sample while a heat flow was generated in the longitudinal direction of the sample in a physical property measurement system PPMS apparatus manufactured by Quantum Design, and an electromotive force generated between both ends in the width direction of the sample was measured at room temperature (300 K). The black arrow (symbol 4) in FIG. 7 shows the heat flow direction in the sample. After the temperatures $T_1$ and $T_2$ were stabilized, a magnetic field was applied to the sample and the voltage $V_{ANE}$ (V) was measured. The white arrow (symbol 5) in FIG. 7 shows the magnetic field direction. The magnetic field was swept from 3T to -3T and from -3T to 3T.

The Nernst coefficient $S_{ANE}$ ($\mu$V/K) was determined using the following formula (1).

$$S_{ANE} \ (\mu V/K) \ = \ V_{ANE} \ (V)/W/\Delta T \ (K)/L_2 \quad (1)$$

Here,

$V_{ANE}$ : the electromotive force (V) generated at both ends in the width direction of the sample,
W: the length (mm) in the width direction of the sample,
$\Delta T$: the temperature difference (K) between the two attachment positions of the temperature probes, and
$L_2$: the distance (mm) in the longitudinal direction of the sample between the two attachment positions of the temperature probes.

The results are shown in Table 1. The measurement results of the Nernst coefficient with respect to the electroconductive molded body formed using the sample mill-pulverized product are illustrated in FIG. 8. In this example, the Nernst coefficient at a temperature of 300 K and in the absence of an applied magnetic field (zero magnetic field) was 0.4 $\mu$V/K.

It was verified that the electroconductive molded body of a powder containing an intermetallic compound $GdCo_5$ as a main component according to the invention has a coercive force exceeding 0.5 T in the measurement of the Nernst coefficient, and exhibits an anomalous Nernst effect in a zero magnetic field.

[Table 1]

| Example No. | | | | Powder sample | | |
|---|---|---|---|---|---|---|
| | | | | Hammer mill-pulverized product | Sample mill-pulverized product | Planetary ball mill-pulverized product |
| Example 1 | Particle size distribution | D10 ($\mu$m) | | 5 | 2 | 3 |
| | | D50 ($\mu$m) | | 44 | 13 | 10 |
| | | D90 ($\mu$m) | | 111 | 44 | 40 |
| | Composition ratio obtained by EDX analysis | Gd:Co atomic ratio | Gd | 1.2 | 1.1 | 1.1 |
| | | | Co | 5.0 | 5.0 | 5.0 |
| | Magnetic properties of powder | Coercive force | (T) | 0.74 | 1.48 | 1.86 |
| | | | (kA/m) | 589 | 1178 | 1480 |
| | Electroconductive molded body | Nernst coefficient at 300 K in zero magnetic field ($\mu$V/K) | | 0.6 | 0.4 | 0.4 |

Reference Signs List

| | |
|---|---|
| 1: | Sample for Nernst effect measurement |
| 2a, 2b: | Electromotive force measurement terminal |
| 31, 32: | Temperature measurement position |
| 4: | Heat flow direction in sample |
| 5: | Magnetic field direction |

**Claims**

1.    A metallic powder, which is a powder containing an intermetallic compound $GdCo_5$ as a main component, and has a cumulative 50% particle diameter D50 of 1 to 150 $\mu$m and a cumulative 90% particle diameter D90 of 250 $\mu$m or less in a volume-based particle size distribution as determined by a laser diffraction/scattering method.

2.    A method for producing the metallic powder according to claim 1, comprising:

an alloy ingot preparation step of solidifying a molten metal of a Gd-Co-based alloy to obtain an alloy ingot containing an intermetallic compound $GdCo_5$ as a main component; and
a pulverizing step of pulverizing the alloy ingot to obtain a powder.

3.    An electroconductive molded body of a powder containing an intermetallic compound $GdCo_5$ as a main component.

4.    The electroconductive molded body according to claim 3, wherein the powder containing an intermetallic compound $GdCo_5$ as a main component has a cumulative 50% particle diameter D50 of 1 to 150 $\mu$m and a cumulative 90% particle diameter D90 of 250 $\mu$m or less in a volume-based particle size distribution as determined by a laser diffraction/scattering method.

5. The electroconductive molded body according to claim 3, which is a sintered body of a powder containing an intermetallic compound $GdCo_5$ as a main component.

6. The electroconductive molded body according to claim 3, which exhibits a Nernst coefficient of 0.2 $\mu$V/K or more at a temperature of 300 K in the absence of an applied magnetic field.

7. A thermoelectric conversion element, formed using the electroconductive molded body according to any one of claims 3 to 6.

[Fig.1]

[Fig.2]

[Fig.3]

[Fig.4]

[Fig.5]

[Fig.6]

[Fig.7]

[Fig.8]

## INTERNATIONAL SEARCH REPORT

| International application No. |
| --- |
| **PCT/JP2024/024980** |

### A. CLASSIFICATION OF SUBJECT MATTER

*B22F 1/00*(2022.01)i; *B22F 1/05*(2022.01)i; *B22F 9/04*(2006.01)i; *C22C 1/00*(2023.01)i; *C22C 1/02*(2006.01)i; *C22C 1/04*(2023.01)i; *C22C 1/047*(2023.01)i; *C22C 19/07*(2006.01)i
FI: B22F1/00 M; B22F1/05; B22F9/04 C; C22C1/00 Q; C22C1/02; C22C1/04 B; C22C1/047; C22C19/07 Z

According to International Patent Classification (IPC) or to both national classification and IPC

### B. FIELDS SEARCHED

Minimum documentation searched (classification system followed by classification symbols)

B22F1/00; B22F1/05; B22F9/04; C22C1/00; C22C1/02; C22C1/04; C22C1/047; C22C19/07

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | JP 51-52319 A (TOHOKU METAL IND LTD.) 08 May 1976 (1976-05-08)<br>claims | 3, 5 |
| A | WO 2021/215529 A1 (THE UNIVERSITY OF TOKYO) 28 October 2021 (2021-10-28) | 1-7 |
| A | JP 2021-145116 A (THE UNIVERSITY OF TOKYO) 24 September 2021 (2021-09-24) | 1-7 |

☐ Further documents are listed in the continuation of Box C.   ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **07 August 2024** | **20 August 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/024980**

| Patent document cited in search report | | | Publication date (day/month/year) | Patent family member(s) | | | Publication date (day/month/year) |
|---|---|---|---|---|---|---|---|
| JP | 51-52319 | A | 08 May 1976 | (Family: none) | | | |
| WO | 2021/215529 | A1 | 28 October 2021 | US | 2023/0180614 | A1 | |
| | | | | EP | 4141976 | A1 | |
| | | | | CN | 115485867 | A | |
| JP | 2021-145116 | A | 24 September 2021 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019009308 A
- JP 2020153668 A
- JP 2023002425 A
- JP 2021145116 A